# EUROPEAN PATENT APPLICATION

(11) **EP 4 852 326 A1**
(43) Date of publication of application: **09.12.2026**
(21) Application number: 25180773.1
(22) Date of filing: 04.06.2025
(51) Int. Cl.: H03M 1/16, H03M 3/00

(54) **RESISTOR-CAPACITOR DELAY FILTERING WITH COMPLEX ZEROS FOR ANALOG-TO-DIGITAL CONVERTER**

(71) Applicant: NXP B.V., 5656 AG Eindhoven (NL)
(72) Inventor: LIU, Qilong, 5656AG Eindhoven (NL); BOLATKALE, Muhammed, 5656AG Eindhoven (NL); ARALIOGLU, Arda, 5656AG Eindhoven (NL); BAJORIA, Shagun, 5656AG Eindhoven (NL); BREEMS, Lucien Johannes, 5656AG Eindhoven (NL)
(74) Representative: Schwarzweller, Thomas

(57) **Abstract**

A mixed-signal device includes an ADC (analog-to-digital converter) having a quantizer, a DAC (digital-to-analog converter), and a delay-matching filter. The delay-matching filter includes a first RC (resistor-capacitor) analog filter electrically coupled between an input of the quantizer and an output of the DAC and a second RC analog filter electrically coupled in parallel with the first RC analog filter to form a parallel combination of filters having complex zeros at frequencies lower than a sampling frequency of the ADC.

## Description

### TECHNICAL FIELD

This disclosure relates generally to analog delay filters, and more particularly to delay matching filters having complex zeros for use in analog-to-digital converters (ADCs).

### BACKGROUND

Continuous-time pipeline ADCs (analog-to-digital converters) and continuous-time multi-stage noise shaping (MASH) ADCs include multiple converter stages arranged in series. A typical converter stage includes a signal node that carries an analog signal. The signal node is coupled to a quantizer, which converts the analog signal to a digital signal. A DAC (digital to analog converter) receives the digital signal from the quantizer and converts the digital signal to an output signal, which represents the quantizer's digital output in analog form. A subtracting circuit subtracts the DAC's output signal from a delayed version of the analog signal carried on the signal node. The result of this subtraction is a residue signal, which represents a quantization error of the quantizer. The residue signal is then passed from a current ADC stage to a next ADC stage for further processing. The next ADC stage may be similar in construction to the current ADC stage, and quantizer outputs from the different stages may be combined to provide an overall output of the ADC.

A delay-matching filter delays the analog signal described above. Ideally, the delay of the delay-matching filter closely matches a sum of delays incurred by the quantizer and the DAC, such that the inputs to the subtracting circuit are aligned in time.

### BRIEF DESCRIPTION OF THE SEVERAL VIEWS OF THE DRAWINGS

The foregoing and other features and advantages will be apparent from the following description of particular embodiments, as illustrated in the accompanying drawings, in which like reference characters refer to the same or similar parts throughout the different views. The drawings are not necessarily to scale, emphasis instead being placed upon illustrating the principles of various embodiments.
FIG. 1 is a block diagram of an example converter stage of a continuous-time pipeline ADC, which includes a delay-matching filter, according to one or more embodiments.
FIG. 2 is a block diagram of an example converter stage of a continuous-time MASH ADC, which includes a delay-matching filter, according to one or more embodiments.
FIG. 3 is a simplified schematic diagram of a residue-generating loop and an associated amplifier according to one or more embodiments.
FIG. 4 is a simplified schematic diagram of an example delay-matching filter according to one or more embodiments.
FIG. 5 is a phasor diagram showing example characteristics of RC filters used in a delay-matching filter according to one or more embodiments.
FIG. 6 is a plot showing example positions and movements of zeros in the delay-matching filter according to one or more embodiments.
FIG. 7 is a detailed schematic diagram of an example delay-matching filter according to one or more embodiments.
FIG. 8 shows an example method of making a mixed-signal device according to one or more embodiments.
FIG. 9 is a detailed schematic diagram of a specific delay-matching filter according to one or more embodiments.

### DETAILED DESCRIPTION

Some delay-matching filters found in ADC converter stages include networks of resistors and capacitors (RC networks), whereas other delay-matching filters include networks of resistors, inductors, and capacitors (RLC networks). By far, RLC networks are the most desirable from the electronics standpoint, as they allow for flexible placement of complex zeros, as well as complex poles. By contrast, conventional RC networks found in ADC converter stages have been limited to those having only real zeros, as well as negative real poles.

The ideal delay-matching filter contains an infinite number of poles and zeros, and thus any physical implementation of a delay-matching filter is always a compromise. But conventional RC networks present a more severe compromise than RLC networks, given their lack of complex zeros. For this reason, RC networks tend to produce larger residue signals than RLC networks, with the larger residue signals including not only quantization errors but also extraneous signal content. Such extraneous content can degrade ADC performance and impose additional workloads on subsequent converter stages.

Current trends toward miniaturizing continuous-time pipeline ADCs and continuous-time MASH ADCs have made it impractical and costly to use inductors in delay-matching filters, as inductors are physically bulky devices that are not suitable for many integrated circuit applications. As a result, some designers have opted to use conventional RC networks for delay-matching filters, despite their limitations. What is needed, therefore, is a delay-matching filter that reduces extraneous content more effectively than conventional RC networks while avoiding the use of inductors.

The above need is addressed at least in part with an improved delay-matching filter that includes multiple RC filters electrically coupled in parallel to realize a parallel combination having complex zeros. The complex zeros arise from the parallel combination of the RC filters without the need for the individual RC filters themselves to have complex zeros. Advantageously, embodiments of the improved delay-matching filter avoid the bulkiness and impracticality of inductors while providing greater flexibility in placing zeros than was available using conventional RC networks. Such flexibility enables better suppression of extraneous content in residue signals, resulting in more efficient ADC performance.

According to one or more embodiments, a technique for realizing a delay-matching filter includes modeling a transfer function of the delay-matching filter as a quotient of two polynomials, a polynomial numerator and a polynomial denominator. The modeling may be achieved using mathematical estimation, such as Padé approximants, Taylor series, or the like. The transfer function has poles and zeros, and at least some of the zeros are complex.

According to one or more embodiments, the technique further includes decomposing the transfer function into a sum of multiple expressions, e.g., using polynomial decomposition. Each expression has at least one pole, at least one zero, or both at least one pole and at least one zero. In some examples, the decomposition defines the expressions in terms of a set of unknowns, which allow for a family of different possible circuit implementations.

According to one or more embodiments, the technique further includes selecting trial values for the unknowns and implementing the expressions as respective filters that exhibit the behaviors of the expressions with the selected trial values in place. The filters contain resistors and capacitors, but not inductors. The implementations can be constructed based on design experience and/or by using computer-aided design techniques. If the values of resistors and capacitors that result from the trial values are too large or too small for a given target design, the technique can iterate using different values of the unknowns. In some examples, a family of possible circuit implementations is provided, and an implementation is selected which best suits the target design. Once the design of the filters is set, the filters are arranged in parallel to produce a parallel combination having the same behavior as the original transfer function.

One should appreciate that the terms "poles" and "zeros" as used herein in connection with the delay-matching filter are intended to describe only those poles and zeros that are deliberately included in the design of the delay-matching filter. Such terms are not intended to include parasitic poles and zeros that may be found at extremely high frequencies and that do not materially affect circuit behavior at operating frequencies.

Embodiments of the improved technique and electronic devices that are designed using the improved technique will now be described. One should appreciate that such embodiments are provided by way of example to illustrate certain features and principles but are not intended to be limiting.

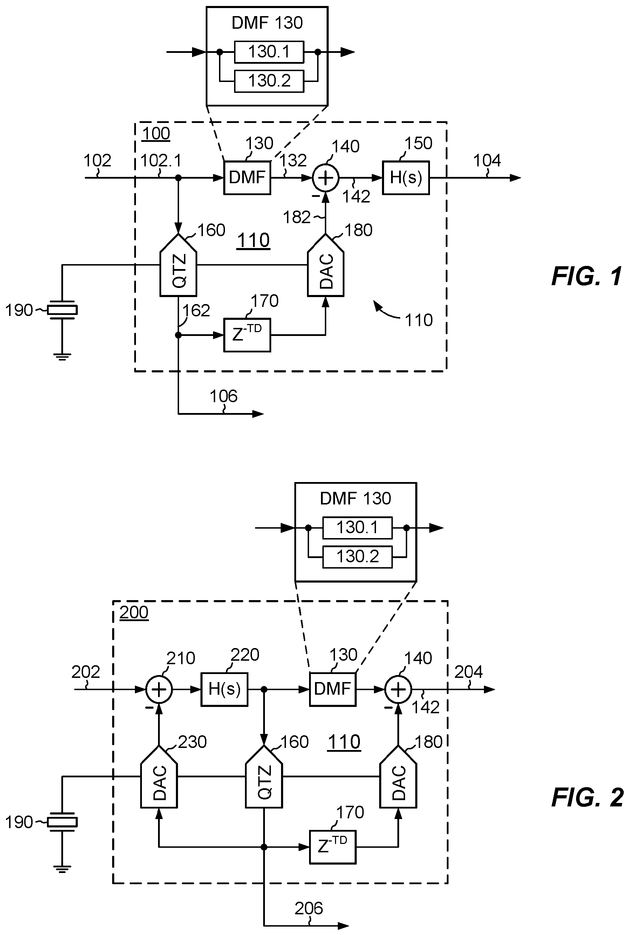

FIG. 1 shows an example ADC stage 100 according to one or more embodiments. The ADC stage 100 is part of a continuous-time (CT) pipeline ADC. The ADC stage 100 includes a delay-matching filter (DMF) 130, a summer 140, and an amplifier (H(s)) 150. The ADC stage 100 further includes a quantizer (QTZ) 160, a delay element (Z^{-TD}) 170, and a DAC 180. Although not shown, some embodiments may further include a signal-processing block between the quantizer 160 and the DAC 180.

When incorporated into a CT pipeline ADC, multiple stages 100 are arranged end-to-end in series, with an output 104 of a current stage 100 connecting to an input 102 of a next stage 100. The stage 100 also provides a digital output 106 (from the quantizer 160), which may be combined with similar digital outputs 106 of other stages 100 to produce an overall digital result of the CT pipeline ADC. The ADC is referred to as "continuous time" because the path from the input 102 to the output 104 is entirely analog, with sampling by the quantizer 160 and conversion by the DAC 180 occurring outside the direct path between input 102 and output 104.

Especially relevant to this disclosure is a residue-generating loop 110, which contains the quantizer 160, the delay-matching filter 130, the summer 140, the DAC 180, and the delay element 170, as these components are involved in generating a residue signal 142, which contains extraneous content to be minimized. By way of example, the residue-generating loop 110 operates as follows. An analog input signal 102.1 at the input 102 travels to both the quantizer 160 and the delay-matching filter 130. The quantizer 160 digitizes the analog input signal 102.1 and presents a digital result 162 at the output 106. The digital result 162 also reaches the DAC 180, which converts the digital result 162 to an analog output signal 182. The analog output signal 182 represents the output of the quantizer 160 in analog form.

While the quantizer 160 and the DAC 180 are operating, the delay-matching filter 130 is delaying the analog input signal 102.1. A delayed signal 132 from the delay-matching filter 130 eventually arrives at the summer 140, which subtracts the DAC output signal 182 from the delayed signal 132, providing the residue signal 142. The amplifier 150 may then amplify the residue signal 142 for downstream processing, e.g., by subsequent stages 100. The residue signal 142 represents the quantization error of the quantizer 160, i.e., the difference between the analog input signal 102.1 to the quantizer 160 and the analog version 182 of the output from the quantizer 160.

Ideally, the delay imposed by the delay-matching filter 130 precisely matches the delay of delay element 170, so that the two inputs to the summer 140 correspond to the same points in time (i.e., the signals 132 and 182 are combined in phase by the summer 140). Any mismatch in these delays means that the two inputs to the summer 140 are not aligned in time, which can cause the residue signal 142 to contain extraneous signal content. As the delay-matching filter 130 is an analog circuit in which inputs and outputs have not only delay, but also amplitude and waveshape, it can also be said that the delay-matching filter 130 has a transfer function that ideally matches the transfer function from the input signal 102.1 to the DAC output signal 182 within the operating frequency range. Indeed, matching the transfer functions of the two paths has the effect of matching not only the delays, but also the amplitudes and waveshapes.

The delay element 170 is not necessarily an actual physical component. Rather, the delay element 170 may instead represent the delays inherent in operations of the quantizer 160 and the DAC 180 in a lumped form. However, nothing precludes the use of a physical delay element, which may be added, for example, to match additional signal-processing delays in the quantizer-to-DAC path. Further, one should appreciate that the quantizer 160 and the DAC 180 operate at a sampling frequency, or at respective sampling frequencies. The sampling frequency or frequencies may be established by a sampling clock 190, which may be used throughout the ADC.

According to one or more embodiments, the delay-matching filter 130 is constructed and arranged to realize complex zeros using a parallel combination of individual RC filters, such as two parallel filters 130.1 and 130.2. The complex zeros improve the performance of the delay-matching filter 130 over a wide range of frequencies, enabling better suppression of extraneous content than could be achieved without them.

FIG. 2 shows another ADC stage 200 according to one or more embodiments. The depicted ADC stage 200 is that of a CT MASH ADC. As above, multiple stages 200 of may be arranged end-to-end in series, with an output 204 of one stage connecting to an input 202 of the next stage 200. An output 206 of the stage 200 provides a quantizer value of the current stage. Digital outputs 206 from all constituent stages of the CT MASH ADC may be combined to produce an overall digital result.

The stage 200 includes some additional components not found in the stage 100, such as a summer 210, a loop filter 220, and a DAC 230. These components form a sigma-delta substage by providing negative feedback that reduces the scale of the signal input to the loop filter 220, thereby relaxing certainly linearity demands. Also, the stage 200 includes the same residue-generating loop 110 as the stage 100, i.e., a quantizer 160, delay element 170, DAC 180, delay-matching filter 130, and summer 140, which operate the same way as described above in connection with the stage 100. As before, the delay element 170 may represent inherent delays in the quantizer 160 and the DAC 180 but does not necessarily correspond to any physical circuit element.

As with the stage 100, the delay-matching filter 130 in the stage 200 is also constructed and arranged to realize complex zeros using a parallel combination of individual RC filters, such as two parallel filters 130.1 and 130.2, and to provide similar benefits.

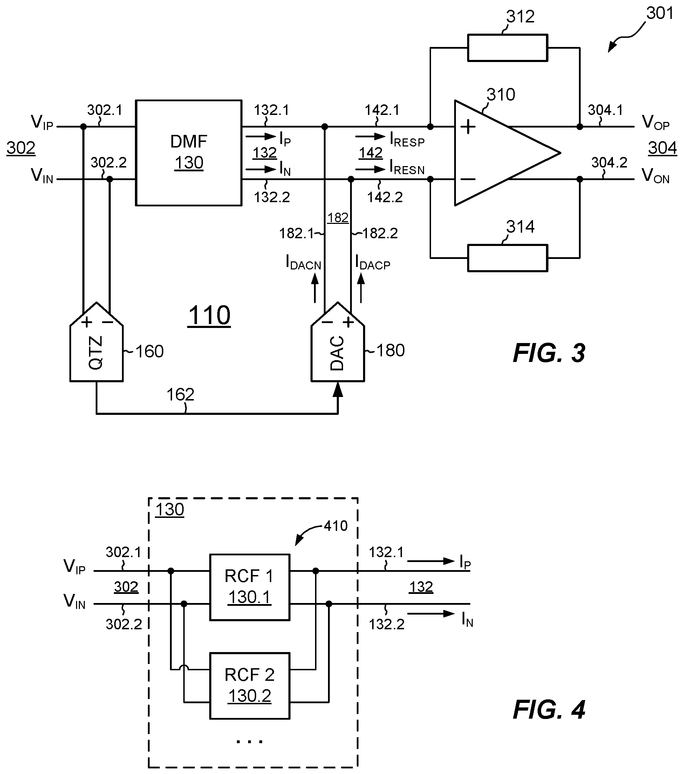

FIG. 3 shows a more specific example of the residue-generating loop 110 and an associated amplifier circuit 301 according to one or more embodiments. The residue-generating loop 110 of FIG. 3 is intended to be representative of the loops 110 described above in connection with FIGS. 1 and 2.

As shown, an input signal 302 is realized as a differential pair of signals having a positive leg 302.1 (V_{IP}) and a negative leg 302.2 (V_{IN}). Both legs of the input signal 302 are provided to a differential input of the delay-matching filter 130, as well as to a differential input of the quantizer 160. The DAC 180 receives the digital output signal 162 from the quantizer 160 (no delay element 170 is shown for simplicity, although the delays inherent to operations of the quantizer 160 and the DAC 180 are present) and generates the analog output 182 as a differential pair having legs 182.1 (I_{DACP}) and 182.2 (I_{DACN}). The DAC outputs 182.1 and 182.2 are provided in the form of respective currents.

The delay-matching filter 130 is configured to delay the input signal 302 and to provide the output 132 as a differential pair, having legs 132.1 (Ir) and 132.2 (I_{N}). These signals are provided in the form of currents, enabling the function of the summer 140 (FIGS. 1 and 2) to be realized directly by connecting the outputs of the delay-matching filter 130 to the outputs of the DAC 180 with the proper polarity in the manner shown. In other words, the summer 140 is realized as a first combining node where the differential legs 132.1 and 182.1 connect, and a second combining node where the differential legs 132.2 and 182.2 connect. To this end, signal 132.1 from the delay-matching filter 130 combines with signal 182.1 from the DAC 180 to provide a positive leg 142.1 (I_{RESP}) of the residue signal 142, and signal 132.2 combines with signal 182.2 to provide a negative leg 142.2 (I_{RESN}) of the residue signal 142.

The amplifier circuit 301 receives and amplifies the residue signal 142. For example, the amplifier circuit 301 includes an amplifier device 310 as well as first and second feedback impedances 312 and 314, such as resistors, coupled between the outputs of amplifier device 310 and the inputs of amplifier device 310. The amplifier device 310 is constructed and arranged to receive a differential input 142 (142.1 and 142.2) and to provide a differential output 304 (304.1 and 304.2, also labeled V_{OP} and V_{ON}).

In an example, the amplifier device 310 has a non-inverting input node (+) and an inverting input node (-), and the amplifier circuit 301 is configured to maintain these input nodes as virtual ground nodes. For example, the feedback operation of the amplifier circuit 301 keeps the input nodes (+ and -) at virtual ground. This virtual-ground arrangement simplifies the construction of the delay-matching filter 130 and the DAC 180 by providing a constant voltage into which they provide their respective currents.

FIG. 4 shows the delay-matching filter 130 of the preceding figures arranged for differential operation. Here, each of the individual RC filters 130.1 and 130.2 is configured to receive differential inputs (302.1 and 302.2) and to provide differential outputs (132.1 and 132.2). The two RC filters 130.1 and 130.2 form a parallel combination 410 of filters. Although FIG. 4 shows two RC filters 130.1 and 130.2 connected in parallel, the ellipses indicate that additional RC filters may be provided and connected in parallel with these two, such as a third RC filter, a fourth RC filter, and so on.

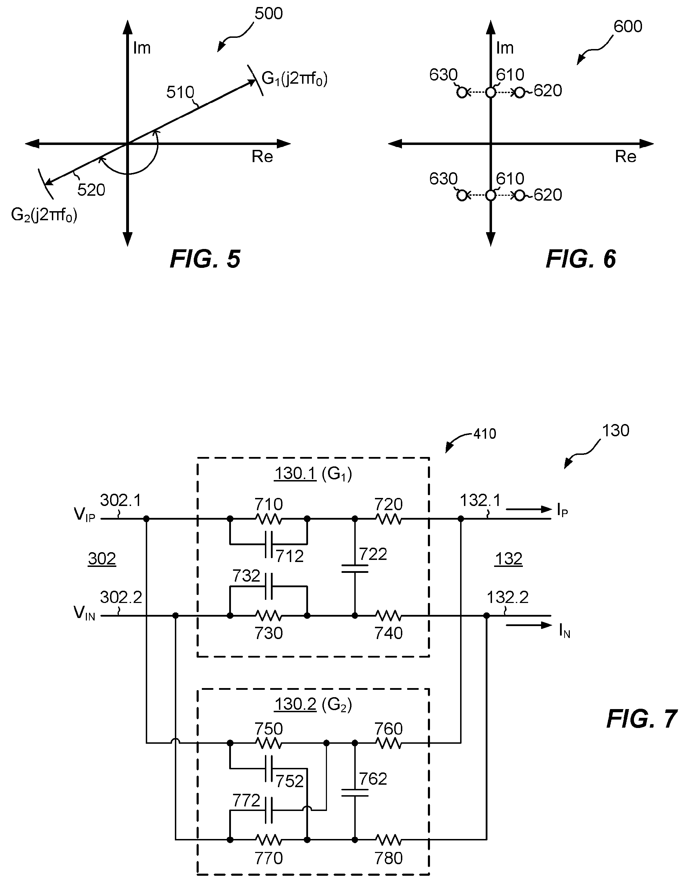

FIGS. 5 and 6 show examples of how complex zeros may be realized and placed by a parallel combination 410 of RC filters, according to one or more embodiments. FIG. 5 shows a phasor plot with real (Re) and imaginary (Im) axes. For this example, it is assumed that the delay-matching filter 130 contains two RC filters 130.1 and 130.2, and that these RC filters have transfer functions G₁ and G₂, respectively. At a certain complex frequency (j2πf₀), the first RC filter 130.1 has magnitude and phase shown by phasor 510, and the second RC filter 130.2 has magnitude and phase shown by phasor 520. The phase difference in this example between phasors 510 and 520 is 180 degrees (π radians), or an odd multiple of 180 degrees, such as 540 degrees, 900 degrees, and so on. If the two phasors 510 and 520 have the same magnitude (not shown), then the zeros produced at frequency j2πf₀ by the parallel combination 410 of RC filters 130.1 and 130.2 are purely imaginary, as illustrated by zeros 610 of FIG. 6 (which also has real and imaginary axes). Note that the zeros shown in FIG. 6 come in complex conjugate pairs.

If phasor 510 for the first RC filter 130.1 has a greater magnitude than phasor 520, as shown, then the result of this mismatch will be to pull the zeros off of the imaginary axis in FIG. 6, such as in the positive real direction as shown with zero 620. Conversely, if phasor 510 for the first RC filter 130.1 has a smaller magnitude than phasor 520, then the result of this mismatch will be to pull the zeros in an opposite direction, such as in the negative real direction as shown with zero 630. Thus, a desired distance of a zero from the imaginary axis can be achieved by adjusting the difference in magnitudes of the phasors 510, 520. One should appreciate that the frequency f₀ is the zero frequency when the magnitudes of phasors 510 and 520 are the same and the phase difference between the phasors are odd multiple of 180 degrees. The frequency f₀ is only an approximation of the zero frequency, however, when the magnitudes of phasors 510 and 520 are different at these phase differences.

FIG. 7 shows a specific example of two RC filters 130.1 and 130.2 that are arranged in parallel to achieve complex zeros, according to one or more embodiments. The depicted example merely illustrates one possible circuit arrangement and is not intended to be limiting.

As shown, the first RC filter 130.1 includes sequentially first and second resistors 710 and 720 electrically coupled in series between input 302.1 and output 132.1, as well as sequentially third and fourth resistors 730 and 740 electrically coupled in series between input 302.2 and output 132.2. First and second capacitors 712 and 732 are electrically coupled in parallel with the resistors 710 and 730, respectively. Also, a third capacitor 722 is electrically coupled between a first intermediate node (between resistors 710 and 720) and a second intermediate node (between resistors 730 and 740).

The second RC filter 130.2 includes sequentially fifth and sixth resistors 750 and 760 electrically coupled in series between input 302.1 and output 132.1, as well as sequentially seventh and eighth resistors 770 and 780 electrically coupled in series between input 302.2 and output 132.2. A fourth capacitor 752 is electrically coupled between the input 302.1 and a third intermediate node (between resistors 770 and 780). Likewise, a fifth capacitor 772 is electrically coupled between the input 302.2 and a fourth intermediate node (between resistors 750 and 760). Also, a sixth capacitor 762 is electrically coupled between a third intermediate node and the fourth intermediate node.

Both of the depicted RC filters 130.1 and 130.2 have one pole and one zero, but some of the capacitors of the filters are arranged differently to provide different behavior. Specific values of the illustrated resistors and capacitors may be varied for achieving different placements of the poles and zeros. For this example, none of the zeros of the individual RC filters 130.1 and 130.2 are complex. However, at least two zeros of the parallel combination 410 are complex (complex conjugates). It should be noted that nothing prevents the individual RC filters 130.1 and 130.2 from containing complex zeros. For example, a single RC filter may itself be constructed as a parallel combination (like the one shown in FIG. 7), which contains complex zeros. It should also be noted that both of the depicted RC filters 130.1 and 130.2 are devoid of (i.e., do not include) inductors between the inputs 302.1, 302.2 and the outputs 132.1, 132.2.

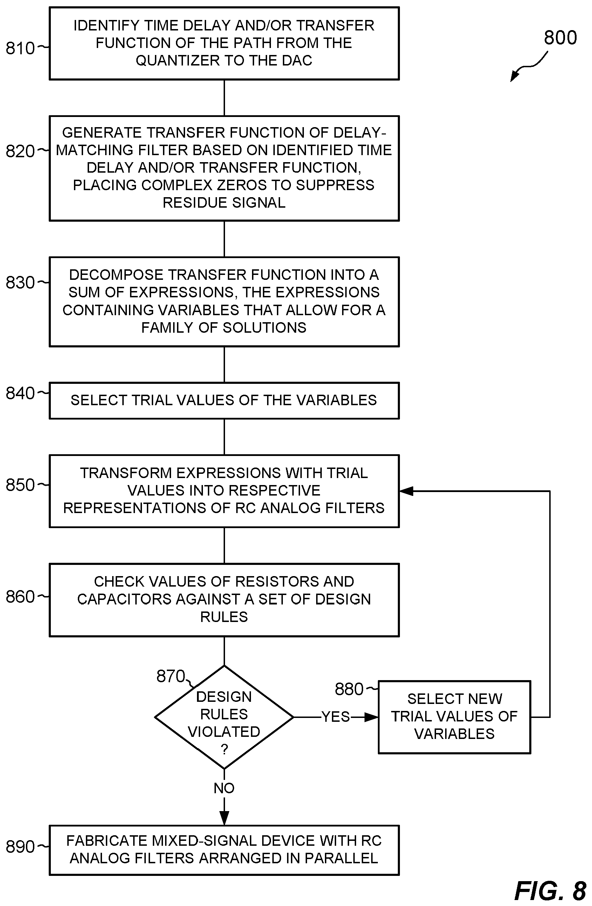

FIG. 8 shows an example method 800 of making a mixed-signal device according to one or more embodiments. The mixed-signal device includes an ADC, such as a CT pipeline ADC or a CT MASH ADC, and the ADC includes a delay-matching filter 130 of the kind described above. Typically, the ADC is a multi-stage ADC, such that the ADC includes multiple delay-matching filters 130 for respective stages.

The method 800 begins at step 810, whereupon the method 800 identifies a time delay TD of the quantizer 160 and DAC 180, as used in one or more stages 100 and/or 200 (e.g., corresponding to the delay imposed by delay element 170). Alternatively or additionally, the method 800 may identify a transfer function of the entire path between the input to the quantizer 160 and the output of the DAC 180. The method 800 may determine the delay TD and/or transfer function based on known design attributes of the quantizer 160, DAC 180 (e.g., sampling period), and any intervening circuitry and/or based on empirical measurements, for example.

At step 820, an ideal transfer function of the delay-matching filter 130 is generated based on the identified time delay or transfer function. For example, the time delay TD may be modeled in the complex frequency domain as *e^{-sTD}*, where "s" is complex frequency. Also, the DAC 180 may be modeled as a non-return-to-zero, zero-order-hold waveform, having a transfer function as follows: $DAC \left(s\right) = {G}_{DAC} ⋅ ZOH \left(s\right) = \frac{1 - {e}^{{sT}_{s}}}{{sT}_{s}} .$ (EQ. 1) As set forth in EQ. 1, *Tₛ* is the sampling period of the DAC 180, which is the same as TD. Also *G_{DAC}* is the transconductance of the DAC 180, which has a particular value *G(0)* at DC (direct current, or zero Hertz).

Combining these models gives the following ideal transfer function of the series combination of the quantizer and the DAC 180, which (assuming no additional delays) is also the ideal transfer function of the delay-matching filter 130: $D \left(s\right) = G \left(0\right) ⋅ {e}^{- sTD} \frac{1 - {e}^{{sT}_{s}}}{{sT}_{s}} .$ (EQ. 2) It is noted, however, that the ideal transfer function *D*(*s*) has an infinite number of poles and zeros, such that it cannot be implemented using a finite number of components.

According to one or more embodiments, the method 800 applies techniques for estimating a delay-matching filter response *G(s)* of the delay-matching filter 130 using a polynomial numerator and a polynomial denominator. Examples of such techniques include Padé approximants and Taylor series. The estimated transfer function is expressed in terms of complex frequency (s), where the poles of the estimated transfer function are values of s that cause the denominator to be 0 and zeros are values of s that cause the numerator to be 0.

As an illustrative example, which is not intended to be limiting, a delay-matching filter response *G(s)* that estimates *D*(*s*) takes the following form: $G \left(s\right) = G \left(0\right) \frac{1 + {b}_{1} s + {b}_{2} {s}^{2}}{\left(1+{sτ}_{1}\right) \left(1+{sτ}_{2}\right)}$ (EQ. 3) Although *G(s)* may accurately estimate *D*(*s*) within the relevant frequency range, *G*(*s*) does not necessarily accurately estimate *D*(*s*) outside that relevant frequency range. Higher-order polynomials generally produce more accurate estimates, but they may not be necessary as long as the response within the relevant frequency range is accurate.

According to one or more embodiments, the delay-matching filter response of EQ. 3 may be optimized to identify suitable values of the coefficients *b₁, b₂, τ₁,* and *τ₂.* For example, the coefficients *b₁* and *b₂* may be adjusted to establish desired placements of complex zeros.

Once the estimated transfer function is established, operation proceeds to step 830, whereupon the transfer function (e.g., EQ. 3) is decomposed into a sum of individual expressions. According to one or more embodiments, the decomposition defines the individual expressions in terms of multiple variables, referred to below as *k₁* and *k_{z1},* as follows: $G \left(0\right) \frac{1 + {b}_{1} s + {b}_{2} {s}^{2}}{\left(1+{sτ}_{1}\right) \left(1+{sτ}_{2}\right)} = {{G \left(0\right) ⋅ \frac{{k}_{1} + {k}_{z 1} {sτ}_{1}}{1 + {sτ}_{1}}}_{︸}}_{G 1 \left(s\right)} + {{G \left(0\right) ⋅ \frac{\left(1-{k}_{1}\right) + \left(\frac{{b}_{2}}{{τ}_{1} {τ}_{2}}-{k}_{z 1}\right) {sτ}_{2}}{1 + {sτ}_{1}}}_{︸}}_{G 2 \left(s\right)} .$ (EQ. 4)

In EQ. 4, variables *k₁* and *k_{z1}* provide freedom in setting the zeros of the individual expressions, i.e., *G*₁(*s*) and *G*₂(*s*). It is noted that these variables affect only the zeros (numerators) of the expressions, not the poles (denominators). Also, selecting a particular value for *k₁* directly implies a corresponding value for *k_{z1},* and vice-versa, as EQ. 5 must remain true for any selection of variable values. In this example, the transfer function is second-order. Higher-order transfer functions may decompose into additional expressions (greater than two expressions). In such cases, greater than two variables may be provided.

EQ. 4 provides a general form for the decomposed expressions. For example, the first expression *G*₁(*s*) includes a zero at a non-zero complex frequency (s) (assuming *k₁* and *k_{z1}* are both non-zero). Setting *k₁* to 0 causes this zero to move to 0 Hertz, while setting *k_{z1}* to 0 causes the zero to disappear entirely from the first expression. The second expression *G*₂(*s*) retains a zero regardless of *k₁* and *k_{z1}.* The variables *k₁* and *k_{z1}* thus support a family of possible combinations of expressions, which translate to a family of possible combinations of circuit representations. At step 840, trial values are selected for the variables *k₁* and *k_{z1}..*

Proceeding now to step 850, the method 800 transforms the decomposed expressions with the selected values of *k₁* and *k_{z1}* into respective representations of RC analog filters, such as the filters 130.1 and 130.2 (FIGS. 4 and 7). Transforming the expressions into filter representations can be achieved in various ways. Skilled practitioners can readily solve each expression for its pole and zero locations and implement corresponding circuits based on known design principles. Also, computer-aided tools, such as Autodesk Fusion, Altium Designer, and CircuitLab, can assist with automatically designing RC circuit representations based on inputted expressions. Upon completion of step 850, RC filter representations are designed which implement the respective expressions based on the trial values of the variables.

In step 860, the method 800 checks the resistor and capacitor values of the RC filter representations. Very large and very small resistor values may be disfavored because they increase noise, area, and/or driving power. Capacitor values should also be reasonable given the target technology. For example, a typical mixed-signal process implements capacitors on parallel metal layers of a semiconductor device, and thus the values of the capacitors should be achievable given the available geometries.

At step 870, the method 800 determines whether any design rules (or preferences) are violated. If yes, operation proceeds to step 880, whereupon a new set of trial values is selected for the variables *k₁* and *k_{z1}..* Operation then returns to step 850, where new RC filter representations are constructed based on the new variable values. Operation continues in this fashion until the design rules (step 870) are satisfied. Finally, once workable representations of the RC filters have been produced, the filter designs may be fixed.

At step 890, a semiconductor fab or other manufacturing plant fabricates a mixed signal device, which includes the delay-matching filter 130 having the workable representations of the RC filters 130.1 and 130.2 arranged in parallel, as shown in FIGS. 4 and 7, for example.

### Example

A specific example will now be described for implementing a delay-matching filter 130 based on a desired delay value, TD, of the quantizer 160 and DAC 180. For this example, it is assumed for illustration that the ADC operates at a sampling rate *F_{S}* of 1.6 GHz (gigahertz) and that the delay TD is 625 ps (picoseconds), which is the same as the sampling period, *Tₛ,* of the ADC. It is further assumed that the DC transconductance *G(0)* of the DAC 180 is 5 millisiemens. Plugging these assumed values into EQ. 2 above gives the following as the frequency response of the series combination of the quantizer 160 and the DAC 180: $D \left(s\right) = 5 mS ⋅ {e}^{- s \left(625 ps\right)} \frac{1 - {e}^{- s \left(625 ps\right)}}{s \left(625 ps\right)} .$ (EQ. 5)

As before, a delay-matching filter response of the delay-matching filter 130 may be expressed as follows: $G \left(s\right) = G \left(0\right) \frac{1 + {b}_{1} s + {b}_{2} {s}^{2}}{\left(1+{sτ}_{1}\right) \left(1+{sτ}_{2}\right)} .$ (EQ. 6) Ideally, *D(s)* from EQ. 5 should match *G(s)* from EQ. 6 as closely as practicable across the relevant frequency range.

Continuing with the above example, a cost function is defined which represents the residue signal 142, as follows: ${\left|Res\left(f\right)\right|}_{max , inband} = {max}_{0 < f < \frac{Fs}{2 OSR}} \left|D\left(j2πf\right)-G\left(j2πf\right)\right| .$ (EQ. 7) Here, "OSR" represents an oversampling rate of the ADC, which is assumed to be four in this example. As an optional simplification, a constraint *τ₂ =* 4*τ₁* may be imposed, which ensures the existence of a solution when determining the other coefficients.

From here, an optimization is performed to identify a set of values of the coefficients *b₁, b₂, τ₁,* and *τ₂* that minimizes the residue signal 142, i.e., |Res(f)|_{max,inband}. For example, the popular MATLAB program has an optimization tool called *fminsearch,* which may be applied for this purpose. Running the optimization tool with the values assumed so far produces the following coefficients, with text in square brackets indicating units:
- ${b}_{1} = 539.10 e - 12 \left[s\right]$
- ${b}_{2} = 118.13 e - 21 \left[{s}^{2}\right]$
- ${τ}_{1} = 79.95 e - 12 \left[s\right] ;$ and
- ${τ}_{2} = 319.86 e - 12 \left[s\right] ;$

It is noted that the above values are independent of *k₁* and *k_{z1}.* As a next step, trial values are selected for *k₁* and *k_{z1}.* For example, setting *k₁* equal to 0.5 causes *k_{z1}* to equal 9.2391. With these choices, EQ. 4 above may be rewritten as follows: $G \left(0\right) ⋅ \frac{1 + {b}_{1} s + {b}_{2} {s}^{2}}{\left(1+{sτ}_{1}\right) \left(1+{sτ}_{2}\right)} = {{G \left(0\right) ⋅ \frac{0.5 + 9.2391 {sτ}_{1}}{1 + {sτ}_{1}}}_{︸}}_{G 1 \left(s\right)} + {{G \left(0\right) ⋅ \frac{0.5 - 4.6197 {sτ}_{2}}{1 + {sτ}_{2}}}_{︸}}_{G 2 \left(s\right)} .$ (EQ. 8)

Substituting the above-listed values for *G(0), τ₁,* and *τ₂,* and scaling the expressions provides the following transfer functions for the individual expressions, *G*₁(s) and *G*₂(s): ${G}_{1} \left(s\right) = \frac{1.478 {e}^{- 9} s + 1}{3.198 {e}^{- 8} s + 400} ; and$ (EQ. 9) ${G}_{2} \left(s\right) = \frac{- 2.956 {e}^{- 9} s + 1}{1.279 {e}^{- 7} s + 400} .$ (EQ. 10)

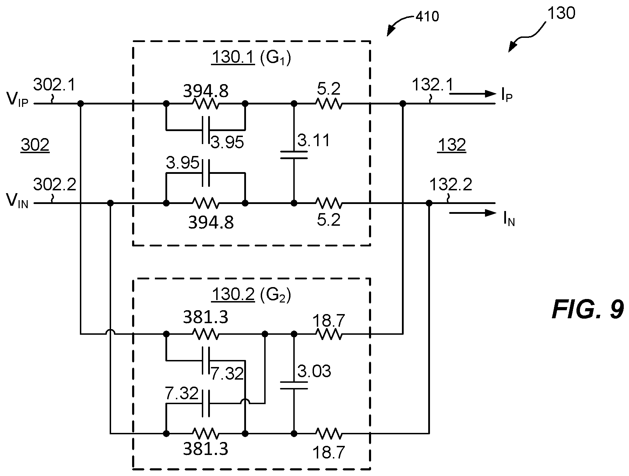

Continuing with the example, individual RC circuit representations that behave in accordance with these transfer functions may be realized using design skills and/or software. FIG. 9 shows the two RC circuit representations of FIG. 7 updated to include component values (resistances and capacitances) that satisfy EQS. 9 and 10 above. In FIG. 9, resistances are in units of Ohms, and capacitances are in units of picofarads. If desired, further iterations may be performed, with different values of *k₁* and *k_{z1}.,* until suitable component values are achieved. A mixed-signal device may then be fabricated accordingly.

An improved delay-matching filter 130 has been described which includes multiple (e.g., two or more) RC filters 130.1 and 130.2 electrically coupled in parallel to realize a parallel combination 410 having complex zeros. The complex zeros arise from the parallel combination 410 without the need for the individual RC filters themselves to have complex zeros. Advantageously, the improved delay-matching filter 130 avoids the bulkiness and impracticality of inductors while also providing greater flexibility in placing zeros than was available using conventional RC networks. Such flexibility enables better suppression of extraneous content in residue signals, resulting in more efficient ADC performance.

Simulation results show an improvement of over 10 dB in suppressing residue signals 142 using the disclosed delay-matching filter 130 as compared with conventional RC filters that do not include complex zeros. Although the suppression levels may not equal those seen when using RLC filters, the new delay-matching filter 130 still provides a significant improvement while avoiding the use of inductors.

According to one or more embodiments, a mixed-signal device includes an ADC (analog-to-digital converter) that includes a quantizer, a DAC (digital-to-analog converter), and a delay-matching filter. The delay-matching filter includes a first RC (resistor-capacitor) analog filter electrically coupled between an input of the quantizer and an output of the DAC, and a second RC analog filter electrically coupled in parallel with the first RC analog filter to form a parallel combination of filters having multiple complex zeros.

According to one or more further embodiments, the delay-matching filter has a time delay that is based at least in part on processing delays of the quantizer and the DAC.

According to one or more further embodiments, the ADC is one of (i) a continuous time pipeline ADC or (ii) a continuous time MASH ADC.

According to one or more further embodiments, the quantizer has an input configured to receive an analog signal and an output configured to provide a quantized signal, and the DAC has an input electrically coupled to the quantizer to receive the quantized signal and an output configured to provide an analog version of the quantized signal. Also, the delay matching filter has an input electrically coupled to the input of the quantizer to receive the analog signal and an output that provides a delayed version of the analog signal. The output of the delay matching filter is electrically coupled to the output of the DAC to provide a residue signal the represents a difference between the delayed version of the analog signal and the analog representation of the quantized signal from the DAC.

According to one or more further embodiments, the first RC analog filter and the second RC analog filter individually have no complex zeros.

According to one or more further embodiments, the complex zeros include at least two complex zeros having real components that are positive.

According to one or more further embodiments, the complex zeros include at least two complex zeros having real components that are negative.

According to one or more further embodiments, the delay-matching filter further includes at least one additional RC analog filter electrically coupled in parallel with the first RC analog filter and the second RC analog filter.

According to one or more further embodiments, the delay-matching filter further includes first and second inputs configured to receive a differential input voltage and first and second outputs configured to provide a differential output current.

According to one or more further embodiments, the ADC further includes an amplifier, and the first and second outputs of the delay-matching filter are respectively coupled to first and second virtual grounds of the amplifier.

According to one or more further embodiments, the first RC analog filter includes one pole and one negative zero, and the second RC analog filter includes one pole and one positive zero.

According to one or more further embodiments, the first RC analog filter includes sequentially first and second resistors electrically coupled in series between the first input node and the first output node, the first and second resistors electrically coupled to each other at a first intermediate node. The first RC analog filter further includes sequentially third and fourth resistors electrically coupled in series between the second input node and the second output node, the third and fourth resistors electrically coupled to each other at a second intermediate node. The first RC analog filter still further includes a first capacitor electrically coupled in parallel with the first resistor, a second capacitor electrically coupled in parallel with the third resistor, and a third capacitor electrically coupled between the first intermediate node and the second intermediate node.

According to one or more further embodiments, the second RC analog filter includes sequentially fifth and sixth resistors electrically coupled in series between the first input node and the first output node, the fifth and sixth resistors electrically coupled to each other at a third intermediate node. The second RC analog filter further includes sequentially seventh and eighth resistors electrically coupled in series between the second input node and the second output node, the seventh and eighth resistors electrically coupled to each other at a fourth intermediate node. The second RC analog filter still further includes a fourth capacitor electrically coupled between the first input node and the fourth intermediate node, a fifth capacitor electrically coupled between the second input node and the third intermediate node, and a sixth capacitor electrically coupled between the third intermediate node and the fourth intermediate node.

According to one or more embodiments, a method is provided of making a mixed-signal device that includes an ADC (analog-to-digital converter) having a quantizer, a DAC (digital to analog converter), and a delay-matching filter. The method includes decomposing a transfer function into a sum of multiple expressions, the transfer function representing a desired delay-matching filter response and having multiple complex zeros. The method further includes transforming the expressions into respective representations of RC (resistor-capacitor) analog filters and fabricating the mixed-signal device such that the RC analog filters are arranged in parallel to provide the delay-matching filter response and the complex zeros.

According to one or more further embodiments, none of the expressions created when decomposing the transfer function include complex zeros.

According to one or more further embodiments, decomposing the transfer function into the sum of multiple expressions includes defining the expressions in terms of multiple variables, and wherein values of the variables are adjustable for providing a family of different combinations of expressions and a corresponding family of different combinations of representations of RC analog filters.

According to one or more further embodiments, decomposing the transfer function into the sum of multiple expressions includes further includes selecting first values for the variables, forming updated expressions based on the first values, transforming the updated expressions into respective first representations of RC analog filters having determined resistor values and capacitor values and selecting second values for the variables different from the first values based on the determined resistor values and capacitor values violating a set of design rules.

According to one or more further embodiments, the method further includes, prior to decomposing the transfer function, generating the transfer function based at least in part on a desired time delay, wherein the desired time delay is based on processing delays of the quantizer and the DAC.

According to one or more embodiments, a continuous-time ADC (analog-to-digital converter) includes a quantizer having an input configured to receive an analog signal and an output configured to provide a quantized version of the analog signal, a DAC (digital-to-analog converter) having an input electrically coupled to the output of the quantizer and an output configured to provide an analog version of the quantized signal, and a delay matching filter having an input coupled to the input of the quantizer and an output coupled to the output of the DAC, the delay matching filter including a first RC (resistor-capacitor) analog filter electrically coupled in parallel with a second RC analog filter to form a parallel combination of filters having multiple complex zeros.

Having described certain embodiments, numerous alternative embodiments or variations can be made. For example, although embodiments have been described for use in continuous-time pipeline and continuous-time MASH ADCs, these are merely examples. Alternatively, the delay-matching filters as described herein may be used with other types of ADCs.

Further, although features have been shown and described with reference to particular embodiments hereof, such features may be included and hereby are included in any of the disclosed embodiments and their variants. Thus, it is understood that features disclosed in connection with any embodiment are included in any other embodiment.

As used throughout this document, the words *"comprising," "including," "containing,"* and *"having"* are intended to set forth certain items, steps, elements, or aspects of something in an open-ended fashion. Also, as used herein and unless a specific statement is made to the contrary, the word *"set"* means one or more of something. This is the case regardless of whether the phrase *"set of"* is followed by a singular or plural object and regardless of whether it is conjugated with a singular or plural verb. Also, a *"set of"* elements can describe fewer than all elements present. Thus, there may be additional elements of the same kind that are not part of the set. Further, ordinal expressions, such as *"first," "second," "third,"* and so on, may be used as adjectives herein for identification purposes. Unless specifically indicated, these ordinal expressions are not intended to imply any ordering or sequence. Thus, for example, a *"second"* event may take place before or after *a "first* event," or even if no first event ever occurs. In addition, an identification herein of a particular element, feature, or act as being a *"first"* such element, feature, or act should not be construed as requiring that there must also be a *"second"* or other such element, feature or act. Rather, the *"first"* item may be the only one. Also, and unless specifically stated to the contrary, *"based on"* is intended to be nonexclusive. Thus, *"based on"* should be interpreted as meaning *"based at least in part on"* unless specifically indicated otherwise. Further, although the term *"user"* as used herein may refer to a human being, the term is also intended to cover non-human entities, such as robots, bots, and other computer-implemented programs and technologies. Although certain embodiments are disclosed herein, it is understood that these are provided by way of example only and should not be construed as limiting.

Also, the foregoing description refers to elements or nodes or features being *"connected"* or *"coupled"* together. As used herein, unless expressly stated otherwise, *"connected"* means that one element is directly joined to (or directly communicates with) another element, and not necessarily mechanically. Likewise, unless expressly stated otherwise, *"coupled"* means that one element is directly or indirectly joined to (or directly or indirectly communicates with, electrically or otherwise) another element, and not necessarily mechanically. Thus, although the schematics and component features shown in the figures depict one exemplary arrangement of elements, additional intervening elements, devices, features, or components may be present in one or more other embodiments of the depicted subject matter.

Those skilled in the art will therefore understand that various changes in form and detail may be made to the embodiments disclosed herein without departing from the scope of the following claims.

## Claims

1. A mixed-signal device, comprising:
an analog-to-digital converter, ADC, that includes a quantizer, a digital-to-analog converter, DAC, and a delay-matching filter, the delay-matching filter including:
a first resistor-capacitor, RC, analog filter electrically coupled between an input of the quantizer and an output of the DAC; and
a second RC analog filter electrically coupled in parallel with the first RC analog filter to form a parallel combination of filters having multiple complex zeros.

2. The device of claim 1, wherein the delay-matching filter has a time delay that is based at least in part on processing delays of the quantizer and the DAC.

3. The device of claim 1 or 2, wherein the ADC is one of: (i) a continuous time pipeline ADC or (ii) a continuous time multi-stage noise shaping, MASH, ADC.

4. The device of claim 3,
wherein the quantizer has an input configured to receive an analog signal and an output configured to provide a quantized signal;
wherein the DAC has an input electrically coupled to the quantizer to receive the quantized signal and an output configured to provide an analog version of the quantized signal,
wherein the delay matching filter has an input electrically coupled to the input of the quantizer to receive the analog signal and an output that provides a delayed version of the analog signal, and
wherein the output of the delay matching filter is electrically coupled to the output of the DAC to provide a residue signal the represents a difference between the delayed version of the analog signal and the analog representation of the quantized signal from the DAC.

5. The device of any preceding claim, wherein the first RC analog filter and the second RC analog filter individually have no complex zeros.

6. The device of any preceding claim, wherein the complex zeros include at least two complex zeros having real components that are positive.

7. The device of any preceding claim, wherein the complex zeros include at least two complex zeros having real components that are negative.

8. The device of any preceding claim, wherein the delay-matching filter further includes at least one additional RC analog filter electrically coupled in parallel with the first RC analog filter and the second RC analog filter.

9. The device of any preceding claim, wherein the delay-matching filter further includes:
first and second inputs configured to receive a differential input voltage; and
first and second outputs configured to provide a differential output current.

10. The device of claim 9, wherein the ADC further includes an amplifier, and wherein the first and second outputs of the delay-matching filter are respectively coupled to first and second virtual grounds of the amplifier.

11. The device of claim 10, wherein the first RC analog filter includes one pole and one negative zero, and wherein the second RC analog filter includes one pole and one positive zero.

12. The device of claim 10 or 11, wherein the first RC analog filter includes:
sequentially first and second resistors electrically coupled in series between the first input node and the first output node, the first and second resistors electrically coupled to each other at a first intermediate node;
sequentially third and fourth resistors electrically coupled in series between the second input node and the second output node, the third and fourth resistors electrically coupled to each other at a second intermediate node;
a first capacitor electrically coupled in parallel with the first resistor;
a second capacitor electrically coupled in parallel with the third resistor; and
a third capacitor electrically coupled between the first intermediate node and the second intermediate node.

13. The device of claim 12, wherein the second RC analog filter includes:
sequentially fifth and sixth resistors electrically coupled in series between the first input node and the first output node, the fifth and sixth resistors electrically coupled to each other at a third intermediate node;
sequentially seventh and eighth resistors electrically coupled in series between the second input node and the second output node, the seventh and eighth resistors electrically coupled to each other at a fourth intermediate node;
a fourth capacitor electrically coupled between the first input node and the fourth intermediate node;
a fifth capacitor electrically coupled between the second input node and the third intermediate node; and
a sixth capacitor electrically coupled between the third intermediate node and the fourth intermediate node.

14. A method of making a mixed-signal device that includes an analog-to-digital converter, ADC, having a quantizer, a digital to analog converter, DAC, and a delay-matching filter, the method comprising:
decomposing a transfer function into a sum of multiple expressions, the transfer function representing a desired delay-matching filter response and having multiple complex zeros;
transforming the expressions into respective representations of resistor-capacitor, RC, analog filters; and
fabricating the mixed-signal device such that the RC analog filters are arranged in parallel to provide the delay-matching filter response and the complex zeros.

15. The method of claim 14, wherein none of the expressions created when decomposing the transfer function individually include complex zeros.
